# DEMANDE DE BREVET EUROPEEN

(11) **EP 2 209 146 A2**
(43) Date de publication de la demande: **21.07.2010**
(21) Numéro de dépôt: 09306148.9
(22) Date de dépôt: 27.11.2009
(51) Int. Cl.: H01L 51/10

(54) **Transistor à source et drain filaires**

(30) Priorité: 15.01.2009 FR 0950198
(71) Demandeur: Commissariat à l'Énergie Atomique et aux Énergies Alternatives, 75015 Paris (FR)
(72) Inventeur: Benwadih, Mohamed, 38000 Grenoble (FR)
(74) Mandataire: Vuillermoz, Bruno

(57) **Abrégé**

Transistor à effet de champ comprenant au moins une grille (1), une couche d'isolant (2), un drain (3), une source (4), un matériau semi-conducteur (50) reliant la source (4) au drain (3), la grille (1) et la couche d'isolant (2) entourant chacun l'ensemble formé par la source (4), le drain (3) et le matériau semi-conducteur, la couche d'isolant (2) étant agencé entre la grille (1) et ledit ensemble.

Le drain (3) et la source (4) sont formés respectivement d'un premier et d'un deuxième conducteurs électriques agencés de manière parallèle et disjointe l'un à l'autre, les premier et deuxième conducteurs étant entourés par une couche du semi-conducteur (50) sur toute leur circonférence et sur au moins une partie de leur longueur.

## Description

### DOMAINE TECHNIQUE

L'invention se rapporte au domaine des transistors à effet de champ.

Plus précisément, l'invention concerne un transistor à effet de champ comprenant au moins une grille, un isolant, un drain, une source, un matériau semi-conducteur séparant la source du drain, la grille et l'isolant entourant chacun l'ensemble formé par la source, le drain et le matériau semi-conducteur, l'isolant étant agencé entre la grille et ledit ensemble.

### ETAT ANTERIEUR DE LA TECHNIQUE

La conception d'un transistor, notamment dans la recherche de la miniaturisation, tient compte de différents critères, notamment celui de la performance recherchée, et celui de la technique de fabrication utilisée.

Les techniques de fabrication des transistors devront de préférence être précises et peu coûteuses.

La performance d'un transistor plan à effet de champ dépend notamment de la géométrie du canal de conduction connectant le drain et la source du transistor. Par exemple, le courant de drain, noté I_{D}, dépend notamment du rapport de la largeur W du canal sur la longueur L du canal (W/L). Une solution pour obtenir un meilleur courant de drain I_{D} consiste par exemple à réduire la longueur L du canal afin d'augmenter le champ électrique E entre le drain et la source, sans nécessiter d'appliquer un potentiel V_{DS} trop grand entre le drain et la source (E= V_{DS} /L).

Par ailleurs, des effets indésirables liés à la géométrie du transistor, tels que les effets de bords, peuvent apparaître et diminuer la performance du transistor.

Pour répondre à ces exigences, le document US 2005/0253134 propose un transistor de type « grille basse » présentant une structure cylindrique permettant d'obtenir un bon rapport W/L et de diminuer les effets de bords. Plus précisément, selon une variante de l'art antérieur, le transistor repose sur une fibre sur laquelle est déposée une couche de semi-conducteur, l'âme de la fibre étant vide. Les électrodes de drain et de source sont réalisées sur la périphérie interne de la couche de semi-conducteur, symétriquement par rapport à l'axe de la fibre. L'ensemble ainsi formé est entouré par une couche isolante, et une couche formant la grille est ensuite déposée sur toute la périphérie externe de cette couche isolante.

Bien que la solution de l'art antérieur permette d'obtenir un bon rapport W/L en jouant sur la longueur du transistor le long de la fibre, cette solution impose des techniques de fabrication complexes et coûteuses.

Dans ce contexte, la présente invention propose un transistor à effet de champ présentant une architecture différente de celle proposée dans l'art antérieur, pouvant être réalisé avec des techniques de fabrication plus simples et moins coûteuses.

### EXPOSE DE L'INVENTION

L'invention a pour objet un transistor à effet de champ comprenant au moins une grille, une couche d'isolant, un drain, une source, un matériau semi-conducteur reliant la source au drain, la grille et la couche d'isolant entourant chacun un ensemble formé par la source, le drain et le matériau semi-conducteur, la couche d'isolant étant agencée entre la grille et ledit ensemble.

Selon l'invention, le drain et la source sont formés respectivement d'un premier et d'un deuxième conducteurs électriques agencés de manière parallèle et disjointe l'un à l'autre, les premier et deuxième conducteurs étant entourés par une couche du matériau semi-conducteur sur toute leur circonférence et sur au moins une partie de leur longueur.

En d'autres termes, deux conducteurs électriques enrobés de semi-conducteur forment respectivement le drain et la source du transistor. Les deux conducteurs sont agencés parallèlement l'un à l'autre, espacés de la longueur du canal de conduction. L'ensemble est noyé dans un isolant qui est entouré par un conducteur constituant la grille.

Dans cette configuration, la longueur du transistor définie par l'épaisseur de semi-conducteur situé entre les deux conducteurs est davantage constante et peut être très fine.

Avantageusement, la longueur du transistor est égale à l'épaisseur de la couche de semi-conducteur ; la longueur est par exemple comprise entre 10 nanomètres et 1 micromètre.

De préférence, la largeur du transistor est égale à la longueur du premier ou du deuxième conducteur.

Selon un mode de réalisation, les premier et deuxième conducteurs sont de forme cylindrique, et la grille peut également être un conducteur cylindrique.

L'architecture filaire ou cylindrique présente l'avantage de proposer une surface de réception des charges plus grandes, et donc de meilleures performances électriques. En particulier, toutes les charges à proximité du drain seront collectées, alors qu'en structure planaire, seules les charges dans la zone comprise entre les surfaces en regard de la source et du drain sont collectées.

Par ailleurs, en raison du fait que la source est parallèle au drain et qu'il n'existe aucune partie saillante dans le drain et la source, les effets de bords sont limités, et les perturbations dans le canal sont réduites, conduisant ainsi à une continuité et une homogénéité électrique dans le canal.

En outre, pour obtenir un bon contrôle des charges du canal par l'intermédiaire d'une tension de grille V_{G,} il faut que la capacité Cₒₓ de l'isolant soit la plus grande possible, l'épaisseur Eₒₓ de l'isolant soit la plus mince possible et que la constante diélectrique εₒₓ du matériau constituant l'isolant soit la plus grande possible. Par exemple, l'épaisseur de l'isolant peut être supérieure à 100 nanomètres.

### BREVE DESCRIPTION DES DESSINS

D'autres caractéristiques et avantages de l'invention ressortiront clairement de la description qui en est faite ci-après, à titre indicatif et nullement limitatif, en référence aux dessins annexés, dans lesquels :
- la figure 1 est vue en perspective des différentes couches constituant le transistor selon un mode de réalisation de l'invention ;
- la figure 2 est une vue éclatée du transistor de la figure 1 ;
- la figure 3 est une vue en section transversale du transistor selon un mode de réalisation de l'invention ; et
- la figure 4 est une représentation schématique de l'intégration de transistors de l'invention au sein d'une structure textile.

### EXPOSE DETAILLE D'UN MODE DE REALISATION PARTICULIER

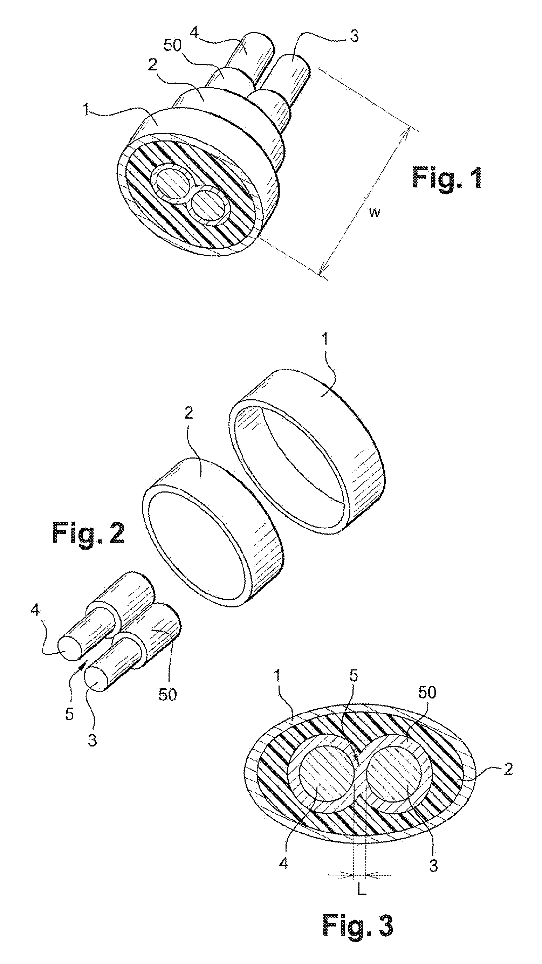

En référence aux figures 1 à 3, un transistor à effet de champ selon un mode de réalisation de l'invention comprend :
- un premier conducteur électrique constituant le drain (3) du transistor,
- et un deuxième conducteur électrique constituant la source (4) du transistor.

Le drain (3) et la source (4) peuvent être constitués de fils à base de matériau métallique ou conducteur, par exemple des fils en argent de 50 micromètres de diamètre.

Le transistor comprend également une couche de semi-conducteur (50) d'épaisseur comprise avantageusement entre 10 nanomètres et 1 micromètre, entourant les premier et deuxième conducteurs sur toute leur circonférence et sur au moins une partie de leur longueur, les premier et deuxième conducteurs étant parallèles et disjoints. La couche de semi-conducteur est de type organique, tel que du polymère cristallin, comme par exemple du pentacène modifié dilué dans du toluène.

Le transistor comprend en outre une couche d'isolant (2) d'épaisseur supérieure à 100 nanomètres, entourant l'ensemble formé par la source (4), le drain (3) et la couche de semi-conducteur (5), et une couche métallique constituant la grille (1) du transistor, entourant la couche d'isolant (2). Cependant, si la rigidité électrique de l'isolant est particulièrement élevée, son épaisseur peut être moindre.

La couche d'isolant peut être en matériau organique, tel que du polyimide, du polystyrène, du fluoropolymère, du PVP (polyvinylphénol), du PMMA (polyméthylmétacrylate), ou autres, et la grille (1) peut être un cylindre à base de matériau métallique ou conducteur.

Ainsi, selon cette configuration, lors du fonctionnement du transistor, le canal (5) de conduction du transistor se crée et est constitué par la couche de semi-conducteur située entre les premier et deuxième conducteurs, sa longueur L étant définie par l'épaisseur de la couche de semi-conducteur situé entre les deux conducteurs, et sa largeur W étant principalement égale à la longueur du premier ou du deuxième conducteur. Il est ainsi possible d'obtenir un bon rapport W/L (grande largeur W et petite longueur L) en jouant sur la longueur des conducteurs électriques et sur l'épaisseur de la couche de semi-conducteur. Il convient en outre de tenir compte de la forme circulaire du drain : en effet, en raison de cette forme particulière, la largeur du canal est plus grande que W, puisque des charges sont collectées sur tout le pourtour du drain, et pas seulement dans la partie en regard de la source.

L'architecture filaire ou cylindrique du transistor ainsi réalisée présente l'avantage de proposer une surface de réception des charges plus grandes, et donc de meilleures performances électriques. Par ailleurs, le drain et la source étant parallèles, le canal est confiné électriquement et n'est pas perturbé par des effets parasites tels que des effets de bords. En outre, le drain et la source ne présentant pas de partie saillante, comme un angle par exemple, les effets de bords sont davantage minimisés.

Le transistor proposé par l'invention ne nécessite par l'utilisation des techniques de fabrication lourdes et coûteuses de la microélectronique, telles que l'utilisation de salle blanche et des techniques de lithographie. En effet, le transistor de l'invention peut être réalisé à bas coût en utilisant par exemple des techniques de fabrication issues du monde du textile, les matériaux organiques utilisés, tels que les polymères pouvant être déposés à l'aide de techniques d'impression, par exemple impression par contact ou par jet d'encre, ou à l'aide de tournette (également connue sous l'expression anglo-saxonne « *spin-coating* »).

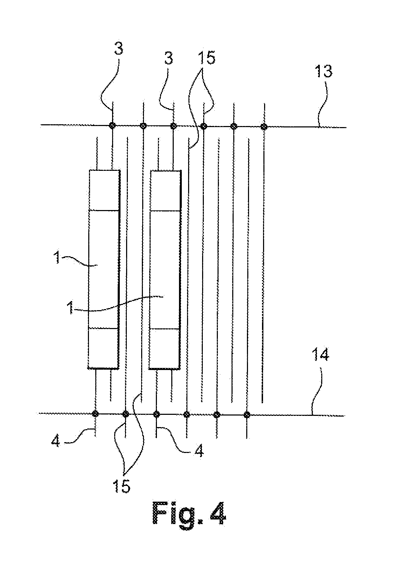

De plus, sa configuration facilite son interconnexion avec d'autres transistors du même type. A cet effet, il suffit d'allonger l'un des conducteurs et de les relier tous ensemble, à l'instar de l'illustration représentée en figure 4.

Au sein de celle-ci, les fils de drain (3) sont allongés d'un coté de la structure, et reliés entre eux au moyen d'un même fil conducteur (13). Corollairement, les fils de source (4) sont allongés d'un autre coté de la structure, et reliés entre eux au moyen d'un même fil conducteur (14). On a représenté par la référence (15) des fils isolants, intercalés entre deux transistors consécutifs. On observe ainsi l'intégration des transistors de l'invention au sein d'une structure textile, présentant des fibres « passives » et des fibres « actives ».

Le transistor de l'invention peut donc être utilisé dans des applications à très bas coûts, notamment sur de grandes superficies de substrats souples à faible durée de vie, par exemple dans l'industrie du textile.

## Revendications

1. Transistor à effet de champ comprenant au moins une grille (1), une couche d'isolant (2), un drain (3), une source (4), un matériau semi-conducteur (50) reliant la source (4) au drain (3), la grille (1) et la couche d'isolant (2) entourant chacun l'ensemble formé par la source (4), le drain (3) et le matériau semi-conducteur, la couche d'isolant (2) étant agencé entre la grille (1) et ledit ensemble,
***caractérisé* en ce que** le drain (3) et la source (4) sont formés respectivement d'un premier et d'un deuxième conducteurs électriques agencés de manière parallèle et disjointe l'un à l'autre, les premier et deuxième conducteurs étant entourés par une couche du matériau semi-conducteur (50) sur toute leur circonférence et sur au moins une partie de leur longueur.

2. Transistor à effet de champ selon la revendication 1, ***caractérisé* en ce qu'**il présente une longueur (L) égale à l'épaisseur de la couche de semi-conducteur (50).

3. Transistor à effet de champ selon l'une des revendications 1 et 2, ***caractérisé* en ce qu'**il présente une longueur (L) comprise entre 10 nanomètres et 1 micromètre.

4. Transistor à effet de champ selon l'une des revendications 1 à 3, ***caractérisé* en ce qu'**il présente une largeur (W) égale à la longueur du premier ou du deuxième conducteur.

5. Transistor à effet de champ selon l'une des revendications 1 à 4, ***caractérisé* en ce que** les premier et deuxième conducteurs sont de forme cylindrique.

6. Transistor à effet de champ selon l'une des revendications 1 à 5, ***caractérisé* en ce que** la couche d'isolant (2) présente une épaisseur supérieure à 100 nanomètres.
